## Europäisches Patentamt

## European Patent Office

## Office européen des brevets

(19)

(11) Veröffentlichungsnummer: **0 386 709**

**A2**

(12) # EUROPÄISCHE PATENTANMELDUNG

(21) Anmeldenummer: **90104285.3**

(22) Anmeldetag: **06.03.90**

(51) Int. Cl.5: **H01L 23/538**

(30) Priorität: **07.03.89 DD 326332**

(43) Veröffentlichungstag der Anmeldung:
**12.09.90 Patentblatt 90/37**

(84) Benannte Vertragsstaaten:
**DE ES FR GB IT NL SE**

(71) Anmelder: **VEB ELEKTRONISCHE BAUELEMENTE "Carl von Ossietzky" TELTOW**
**Ernst-Thälmann-Strasse 10**
**DDR-1530 Teltow(DD)**

(72) Erfinder: **Grützner, Günter, Dipl.-Ing.**

**Karl-Marx-Strasse 87**
**DDR-1532 Kleinmachnow(DD)**
Erfinder: **Markgraf, Conrad, Dipl.-Phys.**
**Willi-Jentsch-Strasse 69**
**DDR-1580 Potsdam(DD)**
Erfinder: **Schubert, Hans, Dr. rer.nat.**
**Ribbeckstrasse 10**
**DDR-1572 Potsdam(DD)**

(74) Vertreter: **von Füner, Alexander, Dr. et al**
**Patentanwälte v. Füner, Ebbinghaus, Finck**
**Mariahilfplatz 2 & 3**
**D-8000 München 90(DE)**

(54) **Edelmetallfreie Chipleiterbrücke und Verfahren zu ihrer Herstellung.**

(57) Die Erfindung betrifft eine edelmetallfreie Chipleiterbrücke und Verfahren zu ihrer Herstellung.

Die Funktionalschichten, die Kantenmetallkontaktschicht und die Leitschicht der Chipleiterbrücke bestehen aus einer Kupfer- oder Nickelschicht, auf die eine Weichlotschicht aufgetragen ist.

Die Funktionalschichten sind einheitlich ausgebildet und werden gleichzeitig aufgetragen.

Auf der Oberseite der Chipleiterbrücke ist zentrisch eine metallfreie, aus Lack gebildete Insel angeordnet, um die die Leitschicht herumgeführt wird.

In einzelnen technologischen Teilschritten wird auf der Substratoberfläche aus Lackschichten eine Insel gedruckt, dann die Ober- und Unterfläche des Substrates mit einem strukturierten Hilfslack bedeckt, Streifen gebrochen, die Streifen chemisch-reduktiv vernickelt, bekeimt und tauchbelotet.

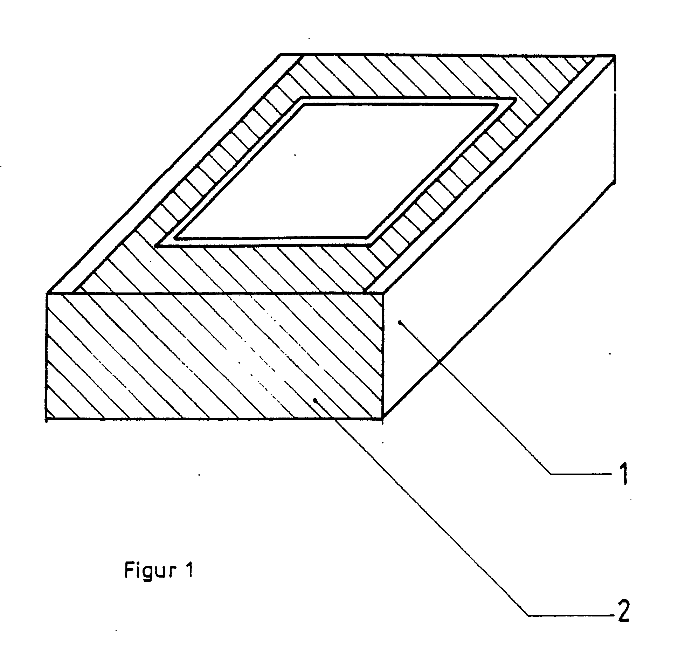

Die Figur 1 stellt die Erfindung am besten dar.

Figur 1

1

2

EP 0 386 709 A2

## Edelmetallfreie Chipleiterbrücke und Verfahren zu ihrer Herstellung

Anwendungsgebiet der Erfindung

Die Erfindung findet auf dem Gebiet der Elektrotechnik/Elektronik, speziell auf dem Gebiet der Fertigung elektronischer bzw. konformer Bauelemente, Anwendung.

Charakteristik des bekannten Standes der Technik

Dem internationalen Stand der Technik entsprechend, bieten Hersteller von Dickschicht-Chipwiderständen unabhängig vom verfügbaren Nennwiderstandsbereich zusätzlich Chipleiterbrücken an, deren Widerstandswert in der Regel 50 m $\Omega$ nicht überschreiten soll und die je nach Baugröße mit maximal 2 A, verschiedentlich aber nur mit 1 A Stromstärke belastet werden können.

Diese Chipleiterbrücken werden in der Aufsatztechnik benötigt, um auf Leiterplatten oder Keramiksubstraten Leiterzüge, die durch ein oder zwei andere Leiterzüge voneinander getrennt sind, entsprechend dem Schaltungsentwurf miteinander zu verbinden. Üblicherweise erfolgt die Herstellung solcher Chipleiterbrücken nach dem gleichen technologischen Verfahren wie die Fertigung von Dickschicht-Chipwiderständen. Allerdings sind Abweichungen notwendig. Entweder wird beim technologischen Teilschritt "Drukken der Widerstandsstruktur" statt der üblichen Widerstandspaste eine Leitpaste verdruckt, oder der technologische Teilschritt "Drucken der Widerstandsstruktur" entfällt gänzlich. Dafür wird beim technologischen Teilschritt "Drucken der Primärkontaktierung" mit einem Druckbild gearbeitet, bei dem die beiden an den Stirnkanten der Deckfläche befindlichen Primärkontakte des Bauelementes durch eine Leitbahn geeigneter Breite miteinander verbunden sind.

Der Nachteil einer solchen Technologie besteht im pro Chip verhältnismäßig hohen Verbrauch von den in der Leitpaste üblicherweise enthaltenen Edelmetallen Silber und Palladium.

Zur Vermeidung dieses Mangels wurden daher technologische Lösungen entwickelt, bei denen die Funktionalschicht des Bauelementes statt aus einer edelmetallhaltigen Leitpaste aus einer chemisch-reduktiven abgeschiedenen und gegebenenfalls durch andere Metallschichten galvanisch verstärkten Nikkelschicht aufgebaut wird (DD 250 002).

Diese technologischen Lösungen haben jedoch durchweg den Nachteil, daß sie erhebliche von der Fertigungstechnologie für Dickschicht-Chipwiderstände abweichen und somit der für eine umfassende Rationalisierung der Technologie unabdingbaren technologischen Vereinheitlichung entgegenstehen.

Zwar kann der gesamte Fertigungszyklus I, also das Drucken, Trocknen und Einbrennen der Leit- und Widerstandspaste eingespart werden, aber dafür sind entweder zusätzliche, mit erheblichem Zeitaufwand verbundene Lackdruck-, Lacktrocknungs- und Lackablöseprozesse sowie chemisch-reduktive und galvanische Abscheidungsprozesse notwendig, oder das Aufbringen der Deckschicht kann nicht wie üblich im Substratverband vorgenommen werden, sondern muß im Streifenverband erfolgen, wozu sich für eine effektive Prozeßgestaltung nur sehr schwer geeignete technische Lösungen finden lassen. Folglich ist allgemein ein erheblicher zeitlicher und technologischer Mehraufwand erforderlich.

Ziel der Erfindung

Ziel der Erfindung ist die effektivere Herstellung von Chipleiterbrücken mit einem Widerstandswert von kleiner als 50 m $\Omega$ .

Darlegung des Wesens der Erfindung

Der Erfindung liegt die Aufgabe zugrunde, edelmetallfreie Chipleiterbrücken in nur wenigen technologischen Teilschritten zu realisieren, wobei sich diese Teilschritte quasi nahtlos in die Technologie einer Dickschicht-Chipwiderstandsfertigung mit edelmetallfreier Kantenmetallisierung einfügen lassen sollen. Diesem Anliegen soll sich auch der Aufbau der Chipleiterbrücken unterordnen, ohne Einschränkungen hinsichtlich der Funktion zuzulassen.

Die Aufgabe wird erfindungsgemäß dadurch gelöst, daß die Funktionalschicht der Chipleiterbrücke aus einer 1 - 5 $\mu$m dicken Nickel- oder Kupferschicht und aus einer auf diese aufgebauten 10 - 15 $\mu$m dicken

2

Weichlotschicht besteht, die sowohl als Kantenmetallkontaktschicht und als Leitschicht einheitlich ausgebildet ist, daß die Leitschicht um eine auf der Chipleiterbrückenoberseite zentrisch angeordnete metallfreie, aus einer Lackschicht oder mehreren Lachschichten bestehende Insel, deren Oberfläche bis zu 32 % der Chipleiterbrückenoberseite beträgt, herumreicht.

Der verfahrenstechnische Teil der Aufgabe wird erfindungsgemäß dadurch gelöst, daß als erster technologischer Teilschritt unmittelbar auf die Substratoberfläche die aus einer oder mehreren Lackschichten bestehende Insel gedruckt und anschließend getrocknet wird. Verwendet wird Polyimidlack.

Die Insel dient der einheitlichen Lageerkennung der Chipleiterbrücken in den Verpackungs- und Bestückungsmaschinen. Damit ist gewährleistet, daß die Technologie für die Herstellung und Verarbeitung der Chipleiterbrücken sich unmittelbar in das Verfahren für die Herstellung von Chipwiderständen integrieren läßt.

Es folgt das Drucken und Trocknen eines Hilfslackes auf der Ober- und Unterfläche des Substrates. Dieser Hilfslack ist eine galvanobeständige Siebdruckfarbe, die gewährleistet, daß nur auf den funktionsbedingten Flächen eine Metallisierung erfolgt.

Nach dem Trennen des Substrates in Streifen erfolgt die chemisch-reduktive Vernickelung. Dafür werden die gesamten Streifen sensibilisiert, aktiviert und damit für die nachfolgende Abscheidung bekeimt.

Nach einer ersten Vernickelungsstufe wird der Hilfslack entfernt, so daß die folgende Nachvernickelung nur auf den bereits metallisierten Flächen, zu denen auch die Funktionsschicht der beschriebenen Leiterbrücke gehört, weitergeführt wird. Die auf diese Weise entstandene Nickelschicht von ca. 3 $\mu$m Dicke wird in einem weiteren Prozeßschritt durch eine Tauchbelotung mit einer ca. 10 - 15 $\mu$m dicken Lotschicht versehen. Nach einer Separierung der Streifen in Einzelbauelemente liegt das fertige Bauelement vor.

Ausführungsbeispiel

Die Erfindung soll einmal durch die Darstellung der Chipleiterbrücke, zum anderen durch die Spezifikation des Fertigungsablaufes in seinen technologischen Teilschritten bezüglich ihrer Realisierung aufgezeigt werden.

Figur 1 zeigt eine Chipleiterbrücke mit den Abmaßen 3,2 x 1,6 mm. Als Ausgangsmaterial werden vorgekerbte Mehrfachträgerkörper der Abmaße 50 x 60 mm verwendet.

Der Fertigungsablauf gliedert sich in die Teilschritte:

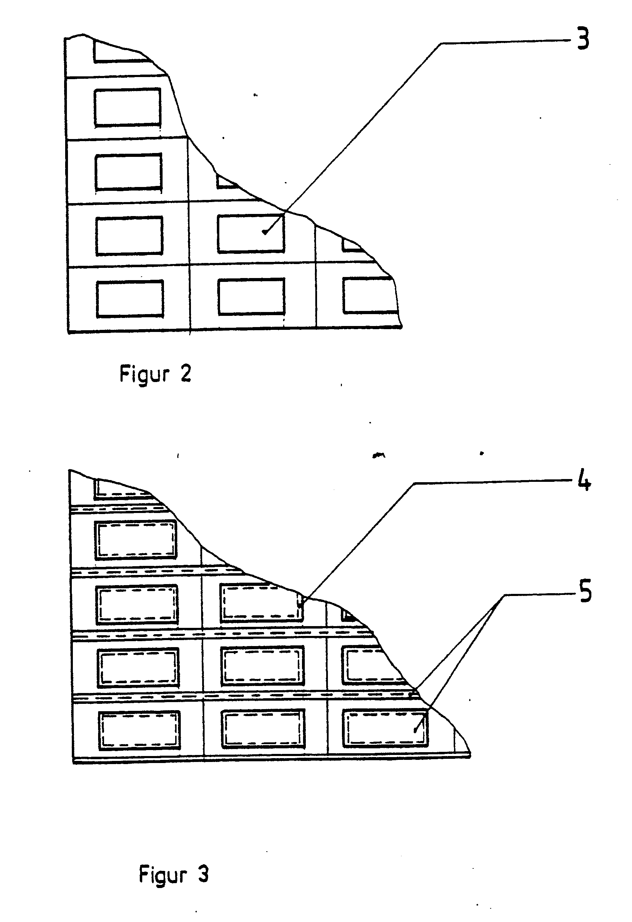

A - Drucken der Inselschicht Polyimidlack (Figur 2)

B - Trocknen/Einbrennen des Polyimidlackes

C - Drucken eines Hilfslackes im Inselbereich zur Sicherung der strukturierten Abscheidung von Nickel auf der Substratoberseite (Figur 3)

D - Trocknen des Hilfslackes

Trockenzeit 15 Minuten

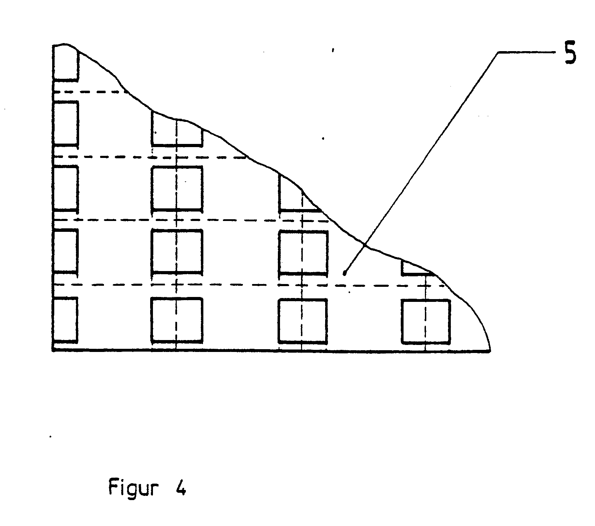

E - Drucken des Hilfslackes (Lackmaske) zur Sicherung der strukturierten Abscheidung von Nickel auf der Substratunterseite (Figur 4)

F - Trocknen des Hilfslackes

Trockenzeit 15 Minuten

G - Streifenbrechen

H - Chemisch-reduktive Vernickelung; Schichtdicke 3 $\mu$m

I - Ablösen des Hilfslackes im Ultraschallbad

Waschmittel: Trichlorethylen

Badtemperatur: 23 ± 2 °C

J - Tauchbelotung

. Benetzung mit Organo-Flußmittel durch Tauchen

. Abtropfen der benetzten Streifen

. Vorwärmen der Streifen auf max. 100 °C, Verweilzeit 90 s

. Tauchbelotung der Streifen im Bad bei 240 °C, Verweilzeit 4 s, Lot LSn 60

K - Chipbrechen

Der Teilschritt H gliedert sich wiederum wie folgt:

| - Sensibilisieren: Badzusammensetzung | |
|---|---|
| $SnCl_2$ 2 $H_2O$ | 10 g/l |
| $CH_3COOH$ | 30 ml/l |
| Isopropanol | 20 ml/l |
| mit deionisiertem $H_2O$ auf 1 l aufgefüllt. | |
| Badtemperatur: | 23 ± 2 °C |
| Verweilzeit: | 10 min |

- Spülen in deionisiertem $H_2O$ bei 20 °C

| - Aktivieren: Badzusammensetzung | |
|---|---|
| $PdCl_2$ 2 $H_2O$ | 5 g/l |
| HCl | max. 15 ml/l |
| $CH_3COONa$ 3 $H_2O$ | 15 g/l |
| mit deionisiertem $H_2O$ auf 1 l aufgefüllt. | |
| Badtemperatur: | 23 ± 2 °C |
| Verweilzeit: | 10 min |

- Spülen in deionisiertem $H_2O$ bei 20 °C

| - Vernickeln: Badzusammensetzung | |
|---|---|
| $NiSO_4$ 7 $H_2O$ | 20 g/l |
| Binatriumsuccinat | 5 g/l |
| Natriumcitrat | 5 g/l |
| Natriumhypophosphit | 15 g/l |
| mit 10%iger $H_2SO_4$ auf einen ph-Wert von 5,2 einstellen und mit deionisiertem $H_2O$ auf 1 l aufgefüllt | |
| Badtemperatur: | 56 ± 2 °C |
| Verweilzeit: | 50 min |

- Spülen in deionisiertem $H_2O$ bei 20 °C

Verwendete Bezugszeichen

1 Flachsubstrat
2 Metallfilm
3 Inselschicht
4 Hilfslack im Inselbereich
5 Lackmaske

## Ansprüche

1. Edelmetallfreie Chipleiterbrücke mit einer auf einem Substrat chemisch-reduktiv abgeschiedenen strukturierten Basisschicht aus Nickel oder Kupfer, gekennzeichnet dadurch, daß die Funktionalschicht der Chipleiterbrücke aus einer 1 - 5 μm dicken Nickel- oder Kupferschicht und aus einer auf diese aufgebauten 10 - 15 μm dicken Weichlotschicht besteht, die sowohl als Kantenmetallkontaktschicht und als Leitschicht einheitlich ausgebildet ist, daß die Leitschicht um eine auf der Chipleiterbrückenoberseite zentrisch angeordnete metallfreie, aus einer Lackschicht oder mehreren Lackschichten bestehende Insel, deren Oberfläche bis zu 32 % der Chipleiterbrückenoberseite beträgt, herumreicht.

2. Verfahren zur Herstellung edelmetallfreier Chipleiterbrükken, gekennzeichnet dadurch, daß vor der chemisch-reduktiven Nickel- oder Kupferabscheidung auf der Oberseite eines Mehrfachträgerkörpers Inseln aus Lack gedruckt und getrocknet werden, und die Metallisierung der Kantenmetallkontaktschicht und der Leitschicht zeitgleich erfolgt, sowie die Tauchbelotung der strukturierten Basisschicht erfolgt, bevor das Chipbrechen erfolgt.

EPAA-38905.9

Figur 1

1

2

EPAA-38905.9

3

Figur 2

4

5

Figur 3

EPAA-38905.9

5

Figur 4